# EUROPEAN PATENT APPLICATION

(11) **EP 0 804 062 A2**
(43) Date of publication of application: **29.10.1997**
(21) Application number: 96120889.9
(22) Date of filing: 27.12.1996
(51) Int. Cl.: H05K 5/02, G01C 22/00

(54) **Electronic device unit**

(30) Priority: 22.04.1996 JP 100483/96; 26.04.1996 JP 107746/96
(71) Applicant: AISIN AW CO., LTD., Anjo-shi Aichi 444-11 (JP)
(72) Inventor: Osaki, Naokazu, Mr., Nishio-shi, Aichi 445 (JP)
(74) Representative: VOSSIUS & PARTNER

(57) **Abstract**

An electronic device unit includes a case (76) having a base (80 - 83) and formed of a heat-conductive material, a circuit board (31) fixed onto the base (80 - 83) by fixing device (91) and having a circuit pattern (96, 97), and an electronic component (35) fixed onto the circuit board (31). The circuit pattern (96, 97) is composed of a circuit portion connected electrically to terminals of the electronic component (35), and a heat conduction portion that is electrically insulated from the circuit portion, formed in a region other than that of the circuit portion, and in contact with the base (80 - 83). In this case, when the electronic component (35) is fixed onto the circuit board (31), the electronic component (35) contacts the heat conduction portion of the circuit pattern (96, 97). Accordingly, the heat generated due to operation of the electronic component (35) is sequentially conducted to the heat conduction portion, the base (80 - 83), and the case (76), and is then radiated from the case (76). Thus, the heat conduction portion of the circuit pattern (96, 97) serves as a heat sink. Therefore, not only can the number of components be reduced, but also processes required for assembly can be reduced, resulting in a lower manufacturing cost of the electronic device unit.

## Description

The present invention relates to an electronic device unit.

### Description of the related art:

Conventionally, an electronic device unit has a structure such that a case contains a circuit board on which are mounted electronic components such as a three-terminal regulator, a power transistor, and a power amplifier.

These electronic components generate heat when operated, and would not operate properly if the generated heat were not radiated. Thus, such an electronic component is attached to a metallic plate which serves as a heat sink and which is in contact with the case, to thereby radiate the generated heat.

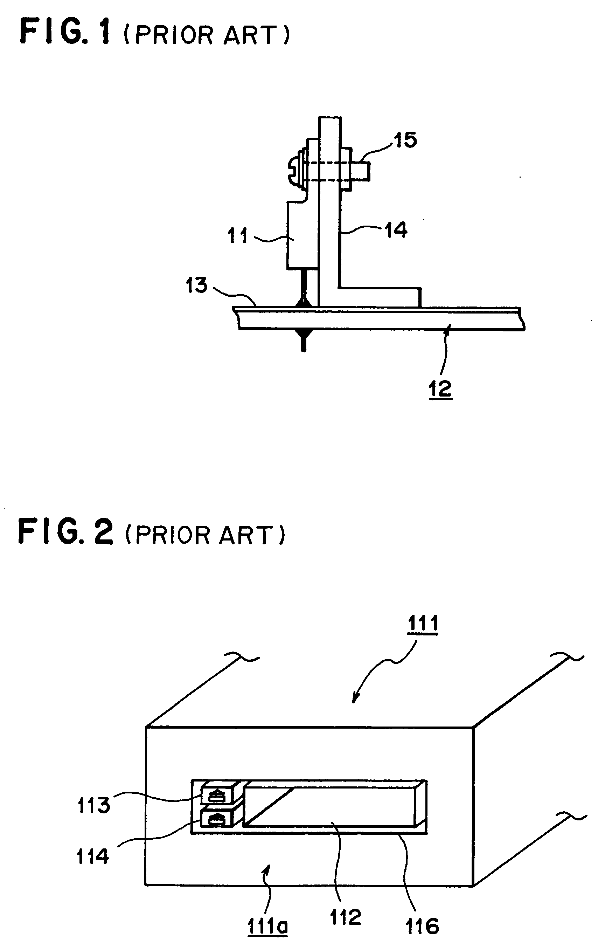

FIG. 1 a view showing a conventional mounting of an electronic component;

In FIG. 1, numeral 11 denotes an electronic component such as a three-terminal regulator, a power transistor, or a power amplifier. Numeral 12 denotes a circuit board for supporting the electronic component 11. A circuit pattern 13 is printed on the surface of the circuit board 12. Numeral 14 denotes a metallic plate which serves as a heat sink and onto which the electronic component 11 is fixed by a bolt 15. The metallic plate 14 is in contact with an unillustrated case.

Accordingly, the heat generated within the electronic component 11 is conducted via the metallic plate 14 to the case and is radiated from the case.

However, in the above-described conventional electronic device unit, due to the metallic plate 14 being interposed between the electronic component 11 and the case, the number of components and processes required for assembly increase accordingly, resulting in a higher manufacturing cost.

Further, in order to contact the metallic plate 14 with the case, the metallic plate 14 must be attached to the case. Therefore, not only must the space for installation of the metallic plate 14 be prepared on a side wall, a rear wall, or the like of the case, but also the use of a bolt or the like for fixing the metallic plate 14 onto the case degrades the appearance of the case.

A conceivable solution to this problem is to fix the electronic component 11 directly onto the case without using the metallic plate 14. This method, however, involves a difficulty in positioning the electronic component 11 when flow soldering is carried out. Thus, a special jig is required for positioning the electronic component 11 during flow soldering. If the electronic component 11 is subjected to flow soldering without the use of the special jig, a force would be applied to leads or the like of the electronic component 11 when the electronic component 11 is fixed onto the case. This force may cause breakage of the leads or a like fault.

Such an electronic device unit is used in a vehicle navigation system. In the vehicle navigation system, in order to upload/download data to/from a host computer through use of personal-computer communication, to create a backup file for personal data, or to perform voice recognition, there must be provided relevant hardware corresponding to the vehicle navigation system.

Specifically, a card interface unit in the form of an electronic device unit is connected to the vehicle navigation system, and a PC card is loaded into the card interface unit to thereby establish a voice interface between a driver and the vehicle navigation system or to enable a driver to upload/download required data. Accordingly, the card interface unit has a slot in its front panel or side wall for inserting/removing a PC card therethrough.

The above-described PC cards are divided into types I, II, and III according to their thickness. The card interface unit allows two PC cards of type I or II or a single PC card of type III to be inserted/removed through the slot.

FIG. 2 is a perspective view of a conventional card interface unit.

In FIG. 2, numeral 111 denotes a card interface unit, and numeral 112 denotes a slot formed in a front panel 111a of the card interface unit 111. In this case, the card interface unit 111 allows two unillustrated PC cards of type I or II to be inserted/removed through the slot 112. In order to accommodate two PC cards of type I or II, unillustrated accommodating sections are formed within the card interface unit 111. Also, the card interface unit 112 allows a single PC card of type III to be inserted/removed through the slot 112.

At a front panel 111a, two eject buttons 113 and 114 are disposed alongside the slot 112. When two PC cards of type I or II are loaded into the above-described accommodating sections, a press of one of the eject buttons 113 and 114 causes a corresponding PC card to be ejected from the corresponding accommodating section.

In order to attain the above-described eject operation, the eject buttons 113 and 114 are respectively attached to the front ends of corresponding unillustrated shafts which extend alongside the accommodating sections toward the rear side of the card interface unit 111 (toward the far side in FIG. 2). Two unillustrated eject arms are disposed in a swingable manner within the card interface unit 111 at the rear portion thereof. One end of each eject arm is linked to the rear end of the corresponding shaft, and the other end of each eject arm abuts the rear end of the corresponding PC card.

Accordingly, when one of the eject buttons 113 and 114 is pressed, the corresponding shaft is retracted. This causes the corresponding eject arm to swing, so that the other end of the eject arm presses the rear end of the corresponding PC card. In this manner, by transmission of a movement of each of the eject buttons 113 and 114 to the rear end of the corresponding PC card, each PC card can be independently ejected (see Japanese Utility Model Applications Laid-Open (kokai) Nos. 7-29767 and 5-55259).

A PC card of type III is loaded into the lower accommodating section within the card interface unit 111. Thus, in order to eject the PC card of type III, only the eject button 114 is pressed.

However, in the conventional card interface unit 111, since the shafts are disposed alongside the accommodating sections, the eject buttons 113 and 114 are disposed quite close to each other.

As a result, when a user wants to eject either one of two loaded PC cards of type I or II and attempts to press the corresponding eject button, the user may mistakenly press a wrong eject button to undesirably eject the other PC card, or may mistakenly press both eject buttons to eject both PC cards. This brings the mistakenly ejected PC card into an incompletely contacted state.

Also, since a relatively large opening 116 must be formed in the front panel 111a in order to accommodate the slot 112 and the eject buttons 113 and 114. This degrades the appearance of the card interface unit 111.

In order to solve this drawback, the eject buttons 113 and 114 may be disposed separately from each other on right and left sides of the slot 112. However, in this case, it becomes difficult to identify which of the right and left eject buttons corresponds to which PC card. Therefore, a user is likely to fail to eject a desired PC card. Also, the lateral dimension of the card interface unit 111 increases accordingly.

An object of the present invention is to solve the above-mentioned problems in the conventional electronic device unit and to provide an electronic device unit which can be manufactured at lower cost, can provide a good appearance, and can facilitate positioning of electronic components when flow soldering is carried out.

Another object of the present invention is to provide an electronic device unit which enables a user to eject a PC card without failure and which provides a good appearance.

To achieve the above objects, the present invention provides an electronic device unit which includes a case having a base and formed of a heat-conductive material, a circuit board fixed onto the base by fixing means and having a circuit pattern, and an electronic component fixed onto the circuit board.

The circuit pattern is composed of a circuit portion connected electrically to terminals of the electronic component, and a heat conduction portion that is electrically insulated from the circuit portion, formed in a region other than that of the circuit portion, and in contact with the base.

In this case, when the electronic component is fixed onto the circuit board, the electronic component contacts the heat conduction portion of the circuit pattern. Accordingly, the heat generated due to operation of the electronic component is sequentially conducted to the heat conduction portion, the base, and the case, and is then radiated from the case.

Therefore, the heat conduction portion of the circuit pattern serves as a heat sink. Thus, not only can the number of components be reduced, but also processes required for assembly can be reduced, resulting in a lower manufacturing cost of the electronic device unit.

Since there is no need for disposing a separate heat sink between the electronic component and the case, the appearance of the case improves, and the electronic component can be readily positioned without the use of a dedicated jig when the circuit board is flow-soldered.

In another electronic device unit of the present invention, the circuit pattern is formed on each of the front and back surfaces of the circuit board, and heat conduction portions of the circuit patterns formed on the both surfaces are interconnected via a through hole.

In this case, when the electronic component is fixed onto the circuit board, the bottom surface of the electronic component is brought into contact with the heat conduction portion of the circuit pattern. Thus, the heat generated due to operation of the electronic component is sequentially conducted to the heat conduction portion of the circuit pattern formed on the front surface of the circuit board, the through hole, the heat conduction portion of the circuit pattern formed on the back surface of the circuit board, the base, and the case, and is then radiated from the case.

In still another electronic device unit of the present invention, the through hole is formed within a hole through which the fixing means is inserted.

In this case, the heat conducted via the through hole to the heat conduction portion of the circuit pattern formed on the back surface of the circuit board is directly conducted to the base. Accordingly, heat conductivity can be improved.

In still another electronic device unit of the present invention, the base is integrally formed with the case by bending.

In this case, since the base is integrally formed with the case by bending, the area in which the base contact with the heat conduction portion of the circuit pattern formed on the back surface of the circuit board can be increased. Accordingly, heat conductivity can be improved.

Still another electronic device unit according to the present invention includes at least two holding frames, each having an accommodating section to be loaded with a PC card, eject mechanisms disposed alongside the corresponding holding frames and adapted to eject independently of each other PC cards loaded in the accommodating sections, and eject buttons for operating the corresponding eject mechanisms.

The press portion of at least one of the eject buttons is displaced from the shaft of the corresponding eject mechanism, thereby increasing the distance between the press portions of the eject buttons.

In this case, a press of the eject button causes the corresponding eject mechanism to operate and thereby press the rear end of the corresponding PC card.

Since the press portions of the eject buttons are sufficiently apart from each other, a user does not mistakenly press a wrong eject button when attempting to press the other eject button. This prevents a wrong PC card from being ejected or two or more PC cards from being ejected together, so that the mistakenly ejected PC card is prevented from being brought into an incompletely contacted state.

Also, there is no need for forming a large opening in the front panel for accommodating the slot and the eject buttons, thereby improving the appearance of the electronic device unit.

Further, a PC card can be ejected without failure.

Moreover, the portion of the front panel between the press portions serves as a rib, thereby increasing the strength of the front panel.

In still another electronic device unit according to the present invention, the holding frames are arranged in layers.

In this case, not only can a PC card of type I or II can be loaded into each of the accommodating sections of the holding frames, but also a PC card of type III can be loaded into one of the accommodating sections.

The above and other objects, features and advantages of the present invention will be apparent from the following detailed description of the preferred embodiments of the invention in conjunction with the accompanying drawings, in which:
FIG. 1 is a view showing a conventional mounting of an electronic component;
FIG. 2 is a perspective view of a conventional card interface unit;
FIG. 3 is a block diagram of an electronic device unit according to a first embodiment of the present invention;
FIG. 4 is a plan view of a circuit board of the electronic device unit according to the first embodiment of the present invention;
FIG. 5 is a plan view of a lower case of the electronic device unit according to the first embodiment of the present invention;
FIG. 6 is a front view of the lower case of the electronic device unit according to the first embodiment of the present invention;
FIG. 7 is a plan view of an upper case of the electronic device unit according to the first embodiment of the present invention;
FIG. 8 is a front view of the upper case of the electronic device unit according to the first embodiment of the present invention;
FIG. 9 is a perspective view of a main portion of the lower case of the electronic device unit according to the first embodiment of the present invention;
FIG. 10 is a sectional view showing the mounting of an electronic component according to the first embodiment of the present invention;
FIG. 11 is a perspective view showing the mounting of the electronic component according to the first embodiment of the present invention;
FIG. 12 is a perspective view of a main portion of a lower case according to a second embodiment of the present invention;
FIG. 13 is a perspective view of a card interface unit according to a third embodiment of the present invention;
FIG. 14 is a plan view of a main portion of a card insertion guide of the card interface unit according to the third embodiment of the present invention;
FIG. 15 is a front view of the main portion of the card insertion guide of the card interface unit according to the third embodiment of the present invention; and
FIG. 16 is a side view of the main portion of the card insertion guide of the card interface unit according to the third embodiment of the present invention.

Embodiments of the present invention will next be described in detail with reference to the drawings.

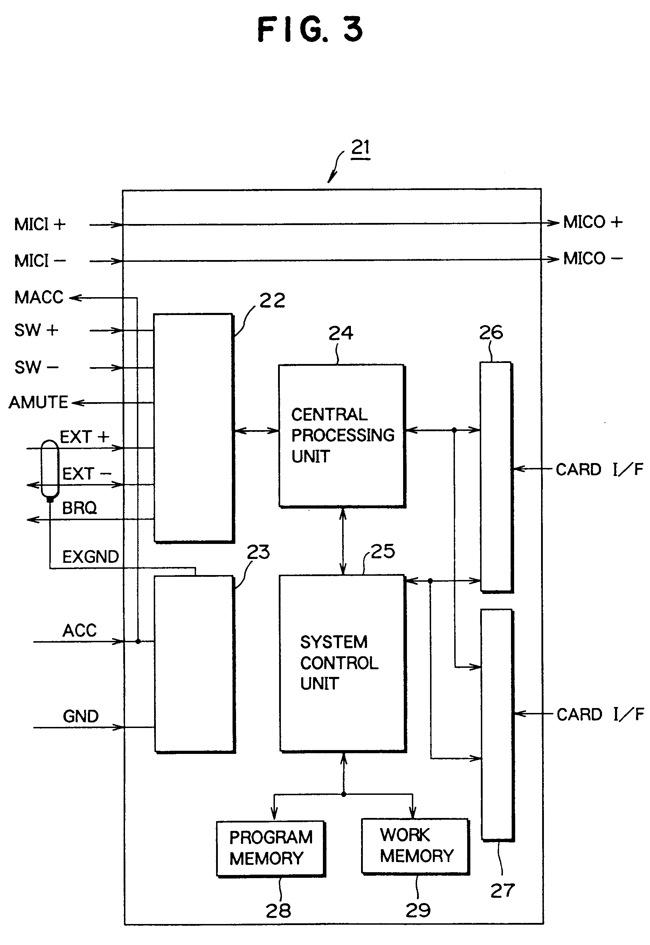

FIG. 3 is a block diagram of an electronic device unit according to a first embodiment of the present invention. In this case, the electronic device unit is a card interface unit connected to a vehicle navigation system.

In FIG. 3, numeral 21 denotes a card interface unit connected to an unillustrated vehicle navigation system. In the vehicle navigation system, in order to upload/download data to/from a host computer through use of personal-computer communication, to create a backup file for personal data, or to perform voice recognition, there must be provided relevant hardware corresponding to the vehicle navigation system.

To attain these objectives of communication, the card interface unit 21 is adapted to be loaded with an unillustrated card to thereby establish a voice interface between a driver and the vehicle navigation system as well as to allow a user to upload/download data to/from a host computer.

The card interface unit 21 includes an external-signal level-conversion block 22 for converting the level of a signal transmitted to and from the vehicle navigation system, a power supply block 23 connected to an unillustrated battery and used for generating a constant voltage, a central processing unit 24 for controlling the entire card interface unit 21, a system control unit 25, card I/F blocks 26 and 27 for controlling interface between a card and the card interface unit 21, a program memory 28 which contains the algorithm for controlling the card interface unit 21, and a work memory 29.

In FIG. 3, MICI+ denotes a positive microphone input, MICI- denotes a negative microphone input, MICO+ denotes a positive microphone output, MICO- denotes a negative microphone output, MACC denotes an accessory voltage for a microphone, SW+ denotes a positive trigger input, SW- denotes a negative trigger input, AMUTE denotes an audio mute signal which is output for lowering an audio output while being linked with the positive trigger input SW+ and the negative trigger input SW-, EXT+ denotes a positive data communication line signal, and EXT- denotes a negative data communication line signal. The positive data communication line signal EXT+ and the negative data communication line signal EXT- are transmitted to and from the vehicle navigation system.

BRQ denotes a bus request signal which requests an unillustrated common bus, EXGND denotes a shield line for grounding the positive data communication line signal EXT+ and the negative data communication line signal EXT-, ACC denotes a vehicle signal accessory voltage which is supplied from the battery and is connected with the microphone accessory voltage MACC, and GND denotes a grounding voltage.

Next will be described a circuit board used in the card interface unit 21.

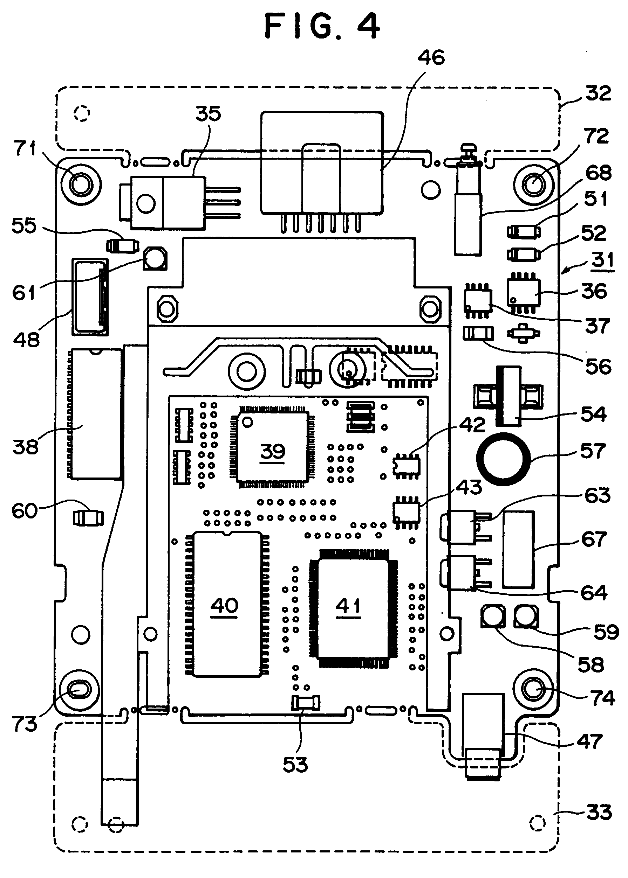

FIG. 4 is a plan view of the circuit board of the electronic device unit according to the first embodiment of the present invention.

In FIG. 4, numeral 31 denotes a circuit board, which is printed with an unillustrated circuit pattern on the front and back surfaces thereof. Working plate portions 32 and 33 are formed integrally with the circuit board 31 at both ends (at upper and lower ends in FIG. 4) of the circuit board 31, and are removed after flow soldering is completed.

Mounted on the surface of the circuit board 31 are electronic components such as ICs 35 to 43, connectors 46 to 48, diodes 51 to 55, capacitors 56 to 61, power transistors 63 and 64, a resistor 67, and a switch 68. The circuit pattern can be formed on either one of the front and back surfaces of the circuit board 31.

Holes 71 to 74 are formed in the circuit board 31 at four corners thereof, and an unillustrated screw is inserted through each of the holes 71 to 74 to thereby mount the circuit board 31 onto a case.

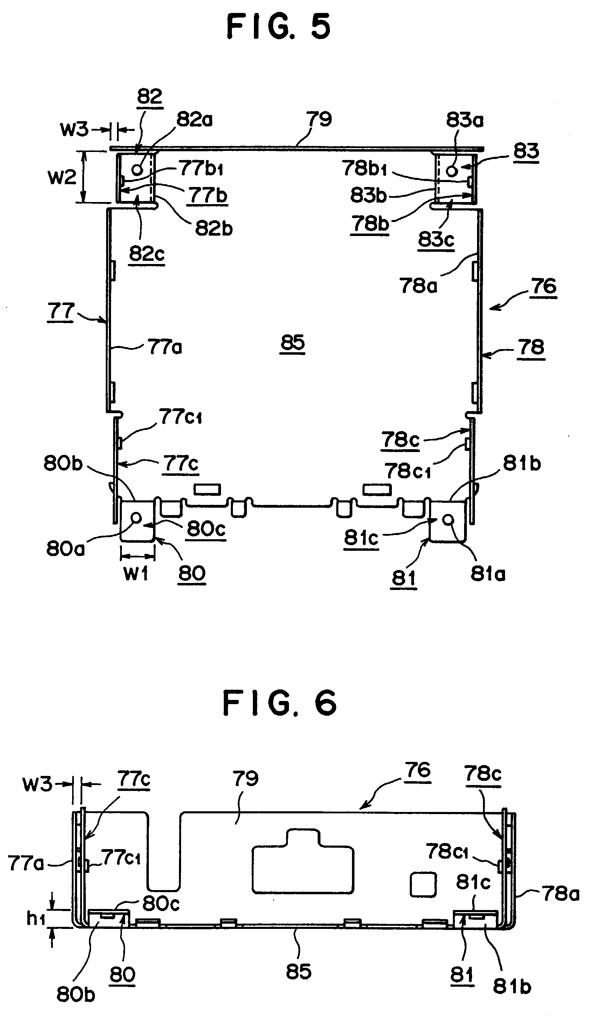

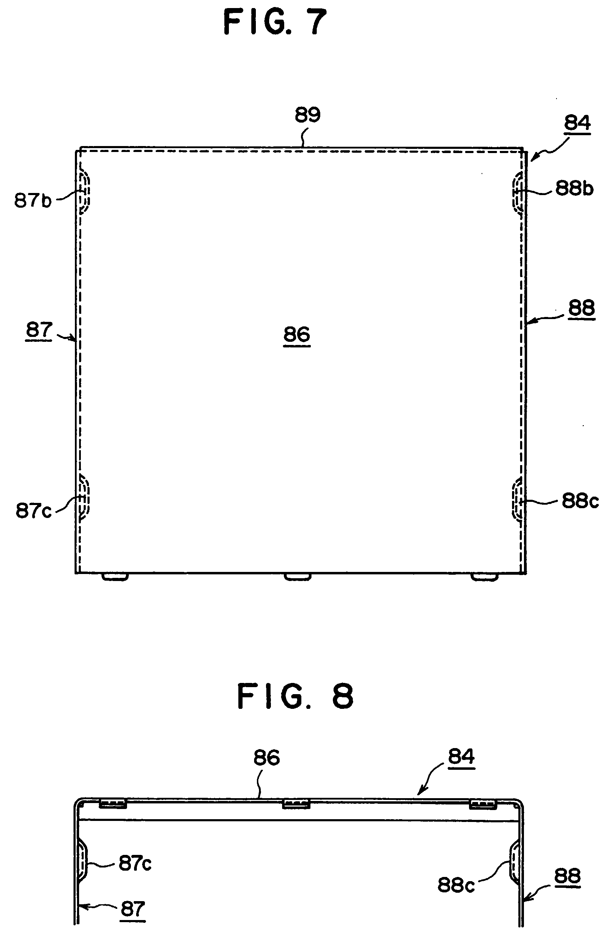

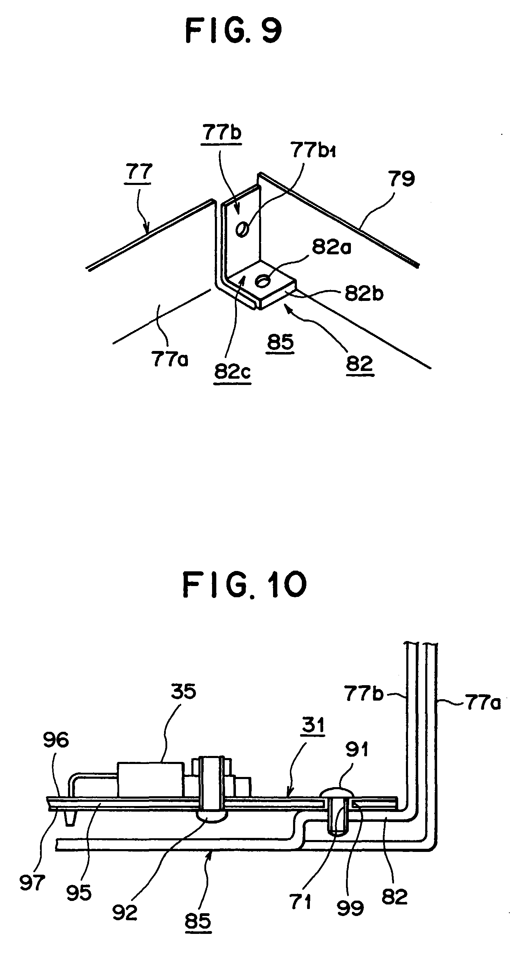

FIG. 5 is a plan view of a lower case of the electronic device unit according to the first embodiment of the present invention. FIG. 6 is a front view of the lower case of the electronic device unit according to the first embodiment of the present invention. FIG. 7 is a plan view of an upper case of the electronic device unit according to the first embodiment of the present invention. FIG. 8 is a front view of the upper case of the electronic device unit according to the first embodiment of the present invention. FIG. 9 is a perspective view of a main portion of the lower case of the electronic device unit according to the first embodiment of the present invention.

In FIGS. 5 to 9, numeral 76 denotes a lower case which is open at its top and front and which is composed of side walls 77 and 78, a rear wall 79, and a bottom panel 85, and numeral 84 denotes an upper case which is open at its bottom and front and which is composed of side walls 87 and 88, a rear wall 89, and a top panel 86. The upper case 84 covers the lower case 76 to thereby form the case. Both the upper case 84 and the lower case 76 or at least the lower case 76 is made of a highly heat-conductive material such as metal in order to radiate heat conducted from unillustrated electronic components.

Bases 80 to 83 for mounting the circuit board 31 (FIG. 4) thereon are integrally formed with the bottom panel 85 by bending at the front ends (on the bottom side in FIG. 5) and rear ends (on the top side in FIG. 5) of the bottom panel 85. Each of the bases 80 and 81 is formed such that a protrusion having a width w1 and protruding forward from the front end of the bottom panel 85 is raised by a height h1. The bases 80 and 81 are composed of vertical portions 80b and 81b and horizontal portions 80c and 81c, respectively. Holes 80a and 81a are formed in the horizontal portions 80c and 81c, respectively. Each of the bases 82 and 83 is formed such that a strip having a width w2 and formed by cutting the side wall 77 or 78 and the bottom panel 85 is raised by a height h1. The bases 82 and 83 are composed of vertical portions 82b and 83b and horizontal portions 82c and 83c, respectively. Holes 82a and 83a are formed in the horizontal portions 82c and 83c, respectively.

The side walls 77 and 78 are composed of central portions 77a and 78a, rear portions 77b and 78b, and front portions 77c and 78c, respectively. The rear portions 77b and 78b and the front portions 77c and 78c are displaced inward from the central portions 77a and 78a by a dimension w3. Holes 77b₁ and 78b₁ are formed in the rear portions 77b and 78b, respectively, while holes 77c₁ and 78c₁ are formed in the front portions 77c and 78c, respectively.

In the side wall 87 of the upper case 84, a depression 87b is formed at a position corresponding to the hole 77b₁ , and a depression 87c is formed at a position corresponding to the hole 77c₁ . In the side wall 88 of the upper case 84, a depression 88b is formed at a position corresponding to the hole 78b₁ , and a depression 88c is formed at a position corresponding to the hole 78c₁ . An unillustrated hole is formed in each of the depressions 87b, 87c, 88b, and 88c. In this case, the depth of the depressions 87b, 87c, 88b, and 88c is identical to the widthwise dimension w3.

Accordingly, when the lower case 76 is properly covered with the upper case 84, the holes of the depressions 87b, 87c, 88b, and 88c are aligned with the holes 77b₁ , 77c₁ , 78b₁ , and 78c₁ , respectively, so that the upper case 84 and the lower case 76 can be fastened together by screw engagement through use of unillustrated screws. Since the head portions of the screws are accommodated within the depressions 87b, 87c, 88b, and 88c, the appearance of the case is improved.

When the electronic components are operated, heat is generated therewithin. For example, in the present embodiment, the IC 35 is a three-terminal regulator, and the ICs 36 and 37 are power amplifiers. Thus, when operated, the ICs 35 to 37 generate heat. Also, the power transistors 63 and 64 generate heat when operated.

The thus-generated heat is conducted to the case via the circuit board 31 and radiated from the case.

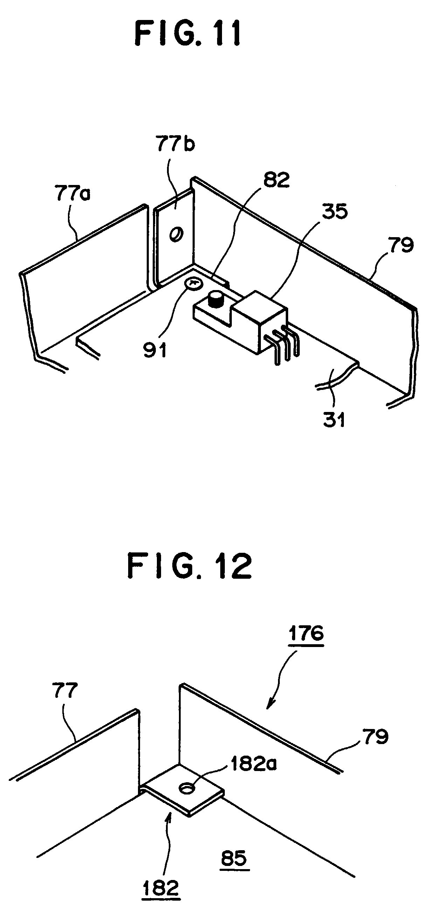

FIG. 10 is a sectional view showing the mounting of an electronic component according to the first embodiment of the present invention. FIG. 11 is a perspective view showing the mounting of the electronic component according to the first embodiment of the present invention.

In FIGS. 10 and 11, a base 82 is formed at a corner of a base panel 85. A circuit board 31 is fixed onto the base 82 by a screw 91, which serves as fixing means. An electronic component such as an IC 35 is fixed onto the circuit board 31 by a screw 92.

The circuit board 31 is composed of a board 95 having an insulating property and circuit patterns 96 and 97, which are formed by printing on the front and back surfaces, respectively, of the board 95. The circuit patterns 96 and 97 are each composed of an unillustrated circuit portion and an unillustrated heat conduction portion. The circuit portion is electrically connected to unillustrated terminals of each electronic component, and includes a common bus, various signal lines, and the like. The heat conduction portion is electrically insulated from the circuit portion and is formed in a solid pattern at a region other than that of the circuit portion. The heat conduction portion serves as a heat sink.

The heat conduction portion of the circuit pattern 96 is connected to that of the circuit pattern 97 by means of through holes 99, each of which being formed in the holes 71 to 74 (FIG. 4). In this case, for example, the inner wall surface of the through hole 99 is plated with metal to thereby connect the heat conduction portions together. Numeral 77a denotes the central portion of the side wall 77 of the lower case 76 (FIG. 5). Numeral 77b denotes the rear portion of the side wall 77. Numeral 79 denotes the rear wall of the lower case 76.

Thus, when an electronic component is fixed onto the circuit board 31, the bottom surface of the electronic component is brought into contact with the heat conduction portion of the circuit pattern 96. Accordingly, the heat generated within the operated electronic component is sequentially conducted to the heat conduction portion of the circuit pattern 96, the through holes 99 formed in the holes 71 to 74, the heat conduction portion of the circuit pattern 97, and the bases 80 to 83, and is then radiated from the lower case 76.

In this case, since the bases 80 to 83 are integrally formed with the bottom panel 85 through bending, the area in which the bases 80 to 83 contact with the heat conduction portion of the circuit pattern 97 can be increased. Accordingly, heat conductivity can be improved.

Also, the heat conduction portions of the circuit patterns 96 and 97 serve as a heat sink, so that not only can the number of components be reduced, but also processes required for assembly can be reduced, resulting in a lower manufacturing cost of the electronic device unit.

Further, since there is no need for disposing a separate heat sink between an electronic component and the case, the appearance of the case improves, and the electronic component can be readily positioned without the use of a dedicated jig when the circuit board is flow-soldered.

Next will be described a second embodiment of the present invention.

FIG. 12 is a perspective view of a main portion of a lower case according to the second embodiment of the present invention.

In FIG. 12, numeral 77 denotes a side wall of a lower case 176, numeral 79 denotes a rear wall, numeral 85 denotes a bottom panel, numeral 182 denotes a base, and numeral 182a denotes a hole formed in the base 182. Part of the side wall 77 is cut and bent so as to become parallel with the bottom panel 85. In this case, the number of processes of the bending work can be reduced, so that not only can work be simplified, but also the manufacturing cost of the electronic device unit can be further reduced.

In the first and second embodiments, the bases 80 to 83 and 182 are formed by bending. Alternatively, they may be formed by extrusion. Further alternatively, a metallic piece having a thickness equal to the height of the bases 80 to 83 and 182 may be welded onto the bottom panel 85 so as to serve as a base.

In the first and second embodiments, an electronic component is fixed onto the circuit board 31 (FIG. 10) on the side of the circuit pattern 96. However, when an electronic component is mounted on the side of the circuit pattern 97, the heat generated within the operated electronic component is conducted to the heat conduction portion of the circuit pattern 97 and then to the bases 80 to 83 and 182. In this case, there is no need for electrically connecting the front and back surfaces of the circuit board 31 for thermal conduction by means of the through holes 99 or the like as in the first and second embodiments.

In order to conduct heat from the front surface of the circuit board 31 to the back surface, the through holes 99 are used in the first and second embodiments. Alternatively, for example, an edge portion of the circuit board 31 may be plated with metal for thermal conduction.

In the first and second embodiments, the circuit board 31 is fixed onto the bases 80 to 83 and 182 by screw engagement through use of the through holes 99. Alternatively, not only may threaded holes other than the through holes 99 be formed, but also the circuit board 31 may be fixed onto the lower cases 76 and 176 by clipping, soldering, or the like.

Next will be described a third embodiment of the present invention.

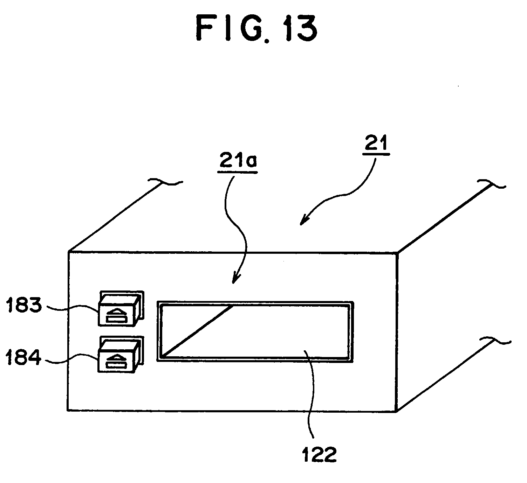

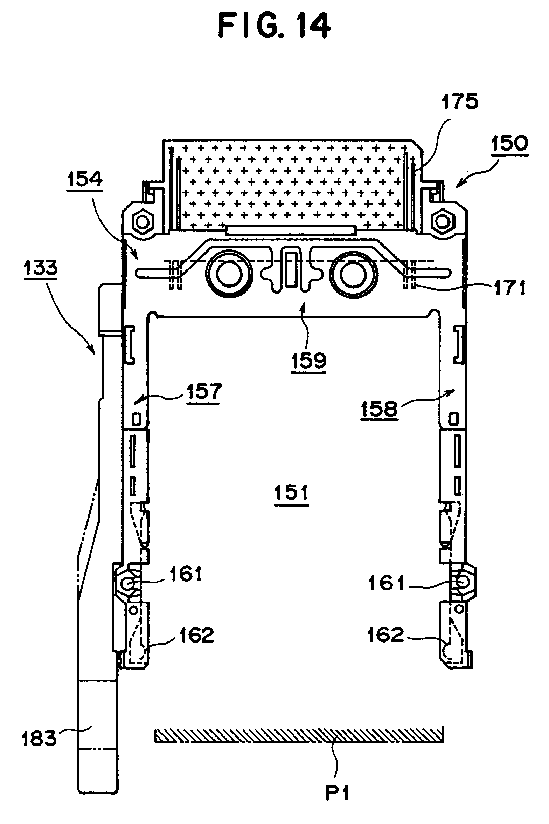

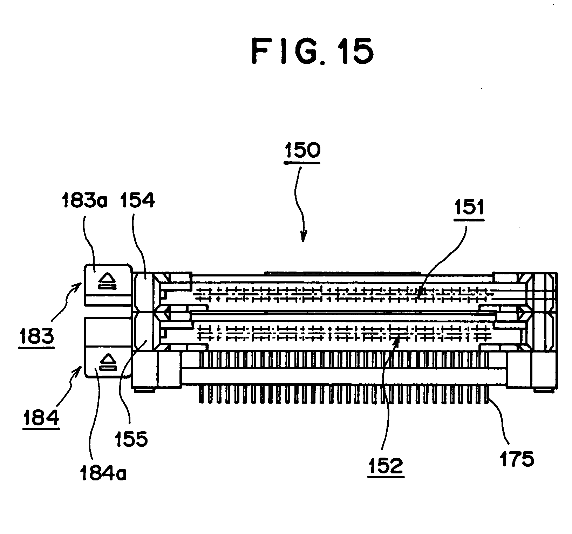

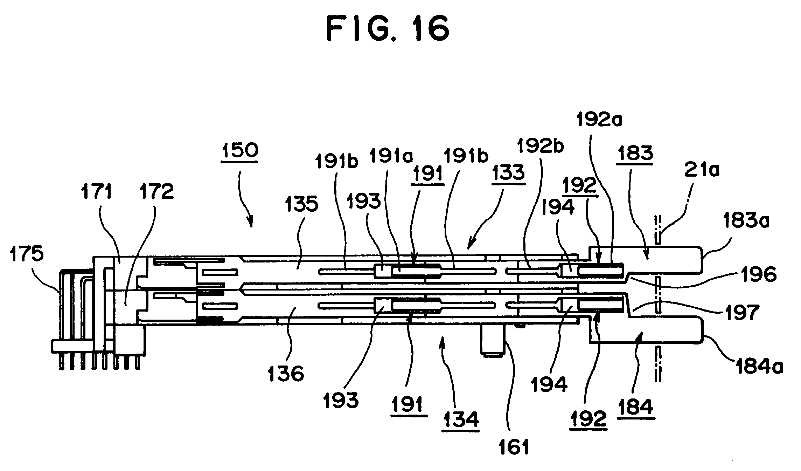

FIG. 13 is a perspective view of a card interface unit according to the third embodiment of the present invention. FIG. 14 is a plan view of a main portion of a card insertion guide of the card interface unit according to the third embodiment of the present invention. FIG. 15 is a front view of the main portion of the card insertion guide of the card interface unit according to the third embodiment of the present invention. FIG. 16 is a side view of the main portion of the card insertion guide of the card interface unit according to the third embodiment of the present invention.

In FIGS. 13 to 16, numeral 21 denotes a card interface unit, and numeral 122 denotes a slot formed in a front panel 21a of the card interface unit 21. In this case, in the card interface unit 21, two unillustrated PC cards of type I or II can be inserted/removed into/from the slot 122. In order to receive two PC cards of type I or II, accommodating sections 151 and 152 are formed within the card interface unit 21. Also, the card interface unit 21 allows one PC card of type III to be inserted/removed thereinto/therefrom. Hatching P1 in FIG. 14 indicates the end portion of a PC card of type I, II, or III when it is loaded.

An unillustrated circuit board is disposed on the bottom panel of the card interface unit 21. Various unillustrated electronic components and a card insertion guide 150 are fixed onto the circuit board. The card insertion guide 150 includes a pair of vertically layered holding frames 154 and 155, which define the accommodating sections 151 and 152, respectively. Three or more holding frames can be vertically layered in order to load three or more PC cards of type I or II into respective accommodating sections.

Each of the holding frames 154 and 155 is composed of a rear portion 159 and side holding portions 157 and 158, the cross section of each being shaped in a lying squarish letter U. When the accommodating sections 151 and 152 are each loaded with a PC card of type I or II, the holding portions 157 and 158 hold both side edges of each loaded PC card. A side contact 161 and an EMI/ESD contact 162 are disposed on the inner surface of each of the holding portions 157 and 158. The side contact 161 is used to ground the case of a PC card, and the EMI/ESD contact 162 serves as a shield terminal against noise.

Card connectors 171 and 172 are attached to the rear ends (left-hand ends in FIG. 16) of the holding frames 154 and 155, respectively. When the accommodating sections 151 and 152 are loaded with respective PC cards, the front end surfaces of the card connectors 171 and 172 are electrically connected to the rear ends of the respective PC cards. A plurality of L-shaped lead wires 175 project from the rear end surfaces of the card connectors 171 and 172. The lead wires 175 establish the electrical connection between the card insertion guide 150 and the circuit board.

Two eject buttons 183 and 184 are disposed alongside the slot 122 in the front panel 21a such that their front ends project from the front panel 21a. When the accommodating sections 151 and 152 are loaded with respective PC cards of type I or II, a press of the eject button 183 or 184 causes the corresponding PC card to be ejected independently of the other PC card.

In order to attain this ejection of a PC card, eject mechanisms 133 and 134 are disposed adjacently to the holding frames 154 and 155, respectively. When the eject button 183 or 184 is pressed to operate the corresponding eject mechanism 133 or 134, this pressing operation is transmitted to the rear end of the corresponding PC card.

The eject mechanism 133 (134) includes a shaft 135 (136) extending backward (to the left in FIG. 16) within the card interface unit 21 and an unillustrated eject arm disposed within the card interface unit 21 in the vicinity of the rear wall of the card interface unit 21. The eject buttons 183 and 184 are integrally formed with the shafts 135 and 136, respectively, at their front ends.

One end of the eject arm is linked with the rear end of the shaft 135 (136). The other end of the eject arm abuts the rear end of the corresponding PC card.

The shafts 135 and 136 are slidably supported by the holding frames 154 and 155, respectively. In order to attain this slidable support, elongated grooves 191 and 192 are formed in each of the shafts 135 and 136, and are respectively engaged with protrusions 193 and 194 formed on the side wall of each of the holding frames 154 and 155.

The elongated groove 191 is composed of a wide slide portion 191a and narrow slits 191b which continuously extend from both ends of the slide portion 191a. The width of the tip of the protrusion 193 is slightly wider than that of the slide portion 191a. Accordingly, the protrusion 193 is inserted into the slide portion 191a while causing the slit 191b to expand.

Likewise, the elongated groove 192 is composed of a wide slide portion 192a and a narrow slit 192b which continuously extends from one end of the slide portion 192a. The width of the tip of the protrusion 194 is slightly wider than that of the slide portion 192a. Accordingly, the protrusion 194 is inserted into the slide portion 192a while causing the slit 192b to expand.

With this structure, the shaft 135 is attached to and held by the holding frame 154, while the shaft 136 is attached to and held by the holding frame 155.

Since the protrusions 193 and 194 can slide along the slide portions 191a and 192a, respectively, a press of the eject button 183 or 184 causes the corresponding shaft 135 or 136 to retreat, causing the corresponding eject arm to swing. As a result, through utilization of the principle of the lever, the other end of the eject arm presses the rear end of a PC card.

Thus, a movement of the eject button 183 or 184 is transmitted as described above to the rear end of a PC card, so that the PC card can be ejected independently of the other PC card.

A PC card of type III is loaded into the accommodating section 152.

When the eject button 184 is pressed, the PC card of type III is ejected.

In the card interface unit 21, two PC cards of type I or II can be loaded in a manner lying one on the other into the single slot 122, and also the eject mechanisms 133 and 134 are respectively disposed alongside the accommodating sections 151 and 152 so as to eject the PC cards independently of each other. Accordingly, the eject mechanisms 133 and 134 are disposed quite close to each other.

In order to provide a sufficient distance between the eject buttons 183 and 184 against this close arrangement of the eject mechanisms 133 and 134, the following measure is employed. As shown in FIG. 16, stepped portions 196 and 197 are formed between the eject button 183 and the shaft 135 and between the eject button 184 and the shaft 136, respectively, behind as well as in the vicinity of the front panel 21a, whereby a press portion 183a of the eject button 183 is displaced upward from the shaft 135, and a press portion 184a of the eject button 184 is displaced downward from the shaft 136. Accordingly, the press portions 183a and 184a can be positioned sufficiently apart from each other.

In the present embodiment, as described above, the stepped portions 196 and 197 are formed between the eject button 183 and the shaft 135 and between the eject button 184 and the shaft 136, respectively. However, stepped portions may be formed in the eject buttons 183 and 184 themselves, or in the vicinity of the front ends of the shafts 135 and 136 themselves. Alternatively, sloped portions or curved portions may be formed in place of the stepped portions 196 and 197.

In the present embodiment, the eject buttons 183 and 184 are integrally formed with the shafts 135 and 136, respectively. Alternatively, the eject buttons may be formed separately from the shafts and fixed to them by unillustrated fixing means.

Further, in the present embodiment, the press portions 183a and 184a are displaced from the shafts 135 and 136, respectively. Alternatively, either one of the press portions 183a and 184a may be displaced from the corresponding shaft.

As described above, since the press portions 183a and 184a are sufficiently apart from each other, a user does not mistakenly press a wrong eject button when attempting to press the other eject button. This prevents a wrong PC card from being ejected or both PC cards from being ejected together, so that a PC card which the user is unwilling to eject is prevented from being brought into an incompletely contacted state.

Also, there is no need for forming a large opening in the front panel 21a for accommodating the slot 122 and the eject buttons 183 and 184, thereby improving the appearance of the card interface unit 21.

Further, a PC card can be ejected without fail.

Moreover, the portion of the front panel 21a between the press portions 183a and 184a serves as a rib, thereby increasing the strength of the front panel 21a.

In the present embodiment, the press portions 183a and 184a of the two eject buttons 183 and 184, respectively, are disposed sufficiently apart from each other. Even when three or more holding frames are arranged in vertical layers, the press portions of three or more eject buttons can be disposed sufficiently apart from each other.

The present invention is not limited to the above-described embodiments. Numerous modifications and variations of the present invention are possible in light of the spirit of the present invention, and they are not excluded from the scope of the present invention.

## Claims

1. An electronic device unit comprising:
a case having a base and formed of a heat-conductive material;
a circuit board fixed onto said base by fixing means and having a circuit pattern; and
an electronic component fixed onto said circuit board,
characterized in that said circuit pattern is composed of a circuit portion connected electrically to terminals of said electronic component, and a heat conduction portion that is electrically insulated from said circuit portion, formed in a region other than that of said circuit portion, and in contact with said base.

2. An electronic device unit according to Claim 1, characterized in that said circuit pattern is formed on each of front and back surfaces of said circuit board, and heat conduction portions of said circuit patterns formed on the both surfaces are interconnected via a through hole.

3. An electronic device unit according to Claim 2, characterized in that said through hole is formed within a hole through which said fixing means is inserted.

4. An electronic device unit according to any one of Claims 1 - 3, characterized in that said base is integrally formed with said case by bending.

5. An electronic device unit comprising:
at least two holding frames, each having an accommodating section to be loaded with a PC card;
eject mechanisms disposed alongside said corresponding holding frames and adapted to eject independently of each other PC cards loaded in said accommodating sections; and
eject buttons for operating said corresponding eject mechanisms,
characterized in that the press portion of at least one of said eject buttons is displaced from a shaft of said corresponding eject mechanism for increasing the distance between the press portions of said eject buttons.

6. An electronic device unit according to Claim 5, characterized in that said holding frames are arranged in layers.
